# EUROPEAN PATENT APPLICATION

(11) **EP 1 407 879 A1**
(43) Date of publication of application: **14.04.2004**
(21) Application number: 02771716.4
(22) Date of filing: 17.05.2002
(51) Int. Cl.: B32B 15/08, H05K 3/38

(54) **HEAT-RESISTANT RESIN FILM WITH METAL LAYER AND WIRING BOARD AND METHOD FOR MANUFACTURING THEM**

(30) Priority: 24.05.2001 JP 2001155171; 13.09.2001 JP 2001277912
(71) Applicant: TORAY INDUSTRIES, INC., Tokyo 103-8666 (JP)
(72) Inventor: OGUNI, Masahiro, Otsu-shi, Shiga 520-0842 (JP); YOKURA, Miyoshi, Otsu-shi, Shiga 520-0844 (JP); YOSHIMURA, Toshio, Fukuoka-shi, Fukuoka 813-0016 (JP)
(74) Representative: Coleiro, Raymond
(86) International application number: PCT/JP2002/004773
(87) International publication number: WO 2002/094558

(57) **Abstract**

The present invention provides a heat-resistant resin film with a metal layer strongly bonded to the heat-resistant resin film without deteriorating the physical properties possessed by the heat-resistant resin film, and a wiring board using the heat-resistant resin film with the metal layer.

The heat-resistant resin film with the metal layer includes a heat-resistant adhesive coated on at least one side of the heat-resistant resin film, and the metal layer provided on the heat-resistant adhesive by at least one of sputtering, vacuum evaporation, and plating. The heat-resistant adhesive has a glass transition temperature (Tg) of 60°C to 250°C, generates 250 ppm or less of gases at 100°C to 300°C, and has an elastic modulus of 0.1 GPa to 3 GPa at 200°C. The wiring board uses the heat-resistant resin film with the metal layer.

## Description

### Technical Field

The present invention relates to a heat-resistant resin film with a metal layer used for manufacturing a flexible wiring board, and a wiring board using the heat-resistant resin film with the metal layer.

### Background Art

Heat-resistant resin films are conventionally used in various fields by making use of properties peculiar to resins. For example, a FPC (Flexible Printed Circuit Board), a TAB (Tape Automated Bonding) film carrier tape, and the like are generally known. Each of these materials is obtained by bonding a heat-resistant resin film of polyimide, or the like, to a metal foil with an adhesive of an epoxy resin, acrylic resin, polyamide resin, or NBR (acrylonitrile-butadiene) type, or the like. At present, the properties of the FPC and the film carrier tape depend upon the performance of the adhesive used, and the excellent heat resistance and other properties possessed by the heat-resistant resin film are not sufficiently utilized. Even when a polyimide film is used, the FPC and film carrier tape generally have a soldering heat resistance of 300°C or less in spite of the heat resistance of polyimide of 350°C or more.

A known method for solving this problem comprises coating an organic polar solvent solution of a polyimide precursor or polyimide directly on a surface of a metal foil without using an adhesive, removing the solvent, and then imidizing the coating. However, this method does not use the adhesive, and thus causes insufficient adhesion between the metal foil and the polyimide, thereby causing the problem of separating a wiring layer from the polyimide when the metal layer is formed in a wiring pattern. Particularly, when fine wiring with a pitch of 50 µm or less is formed, adhesion is absolutely insufficient.

Also, a method of forming a metal thin layer on an epoxy resin, acrylic resin, polyamide resin, or NBR adhesive by a sputtering or wet process, and then further forming a metal layer by plating is known. However, the adhesive has no heat resistance, and thus the soldering heat resistance is 300°C or less.

### Disclosure of Invention

An object of the present invention is to solve the problem of insufficient heat resistance and adhesion, and provide a heat-resistant resin film with a metal layer, which has high heat resistance and high adhesion, and a wiring board obtained by patterning the heat-resistant resin film with the metal layer in a wiring pattern.

The present invention provides a heat-resistant resin film with a metal layer, comprising a heat-resistant adhesive comprising a polyimide resin coated on the heat-resistant resin film, and at least one metal layer provided on the adhesive by sputtering, vacuum evaporation or plating. Also, the present invention provides a wiring board obtained by patterning the heat-resistant resin film with the metal layer in a wiring pattern, and methods of producing the heat-resistant resin film and the wiring board. In the present invention, the heat-resistant adhesive comprising the polyimide resin is combined with at least one metal layer provided by sputtering, vacuum evaporation or plating, thereby exhibiting high heat resistance and high adhesion.

### Best Mode for Carrying Out the Invention

A heat-resistant resin film with a metal layer of the present invention comprises a heat-resistant adhesive coated on the heat-resistant resin film, and the metal layer formed on the adhesive.

The heat-resistant resin film may be a polymeric resin film satisfying either a melting point of 280°C or more, or a maximum allowable temperature of 121°C or more in continuous use for a long period of time defined by JIS C4003.

Preferred examples of the polymeric resin film include films of polyarylate, which is a condensation product of bisphenol and a dicarboxylic acid, polyallylsulfone such as polyethersulfone or polysulfone, a condensation product of benzotetracarboxylic acid and aromatic isocyanate, thermosetting polyimide obtained by reaction of bisphenol, aromatic diamine and nitrophthalic acid, aromatic polyimide, aromatic polyamide, aromatic polyetheramide, polyphenylenesulfide, polyallylether ketone, polyamide-imide resins, aramid resins, polyethylene naphthalate resins, polyether ether ketone resins, and the like; liquid crystal polymer films; and the like. Particularly, aromatic polyimide films and liquid crystal polymer films are preferably used. Examples of commercial products include "Kapton" produced by Du Pont-Toray Co., Ltd., "Upilex" produced by Ube Industries, Ltd., "Apical" produced by Kaneka Corporation, "Mictron" produced by Toray Industries, Inc., "Vectran" produced by Kuraray Co., Ltd., and the like.

Both or one of the surfaces of the heat-resistant resin film is preferably treated by discharge treatment such as corona discharge, atmospheric-pressure plasma treatment, low-temperature plasma treatment, or the like for improving adhesion. Examples of discharge treatment include discharge under near atmospheric pressure, i.e., atmospheric-pressure plasma treatment, corona discharge treatment, low-temperature plasma treatment, and the like. By performing the discharge treatment, adhesion can be improved.

The atmospheric-pressure plasma treatment means a method of discharge treatment in an atmosphere of a treatment gas such as argon, nitrogen, helium, carbon dioxide, carbon monoxide, air, water vapor, or the like. Although the treatment conditions depend upon the treatment apparatus used, the type of the treatment gas used, the flow rate, and the frequency of a power supply, the optimum conditions can be appropriately selected.

The low-temperature plasma treatment can be performed under low pressure, and the method is not limited. An example of the method is a method in which a substrate to be treated is set in an internal electrode-type discharge apparatus comprising a counter electrode comprising a drum electrode and a plurality of rod electrodes, a DC or AC high voltage is applied between the electrodes for discharge with a treatment gas adjusted to 0.01 to 10 Torr, preferably 0.02 to 1 Torr, to produce plasma of the treatment gas, and the surface of the substrate is exposed to the plasma. Although the conditions of the low-temperature plasma treatment depend upon the treatment apparatus used, the type of the treatment gas used, pressure, the frequency of a power supply, etc., the optimum conditions can be appropriately selected. The treatment gas is not limited, and argon, nitrogen, helium, carbon dioxide, carbon monoxide, air, water vapor, oxygen, carbon tetrafluoride, and the like can be used singly or in a mixture.

On the other hand, the corona discharge treatment exhibits a smaller adhesion improving effect than the low-temperature plasma treatment, and it is thus important to select the laminated heat-resistant adhesive.

The heat-resistant resin film preferably has a thickness of 5 to 250 µm, and more preferably 10 to 80 µm. An excessively thin film causes a defect in transfer, and an excessively thick film causes a difficulty in forming a through hole. Therefore, the thickness is preferably in the above range.

In the present invention, as the heat-resistant adhesive, a polyimide resin is individually used, or mixed with another resin. Examples of the resin mixed include epoxy resins, urethane resins, polyamide resins, polyetherimide resins, polyamide-imide resins, and the like. Alternatively at least two types of polyimide resins may be mixed. The adhesive may contain organic or inorganic fine particles, a filler, or the like, and a nucleating agent described below. Particularly, from the viewpoint of heat resistance, polyimide resins composed of an aromatic tetracarboxylic acid and a diamine component are preferably used. More preferably, polyimide resins each obtained by imidizing a polyamic acid obtained by reaction of an aromatic tetracarboxylic acid and 40 mol% or more of siloxane-type diamine are used.

In the present invention, the heat-resistant adhesive preferably has a glass transition temperature (Tg) of 60°C to 250°C, and more preferably a glass transition temperature of 60°C to 230°C. With a glass transition temperature of less than 60°C, heat resistance deteriorates to cause a defect in a high-temperature process using a lead-free solder. With a glass transition temperature of over 250°C, adhesion to the metal layer provided on the heat-resistant adhesive undesirably deteriorates.

In the present invention, the heat-resistant adhesive preferably has an elastic modulus of 0.1 GPa to 3.0 GPa at 200°C, and more preferably 0.3 GPa to 2.0 GPa at 200°C. With an elastic modulus of less than 0.1 GPa at 200°C, heat resistance undesirably deteriorates. With an elastic modulus of over 3.0 GPa at 200°C, adhesion to the metal layer provided on the heat-resistant adhesive undesirably deteriorates.

Furthermore, in the present invention, the amount of the gases generated from the heat-resistant adhesive at a heating temperature of 100°C to 300°C is preferably 250 ppm or less, more preferably 150 ppm or less, and most preferably 100 ppm or less. The amount of the gases generated at a heating temperature of 100°C to 300°C is measured by thermogravimetry, micro decomposition and gravimetry, or mass spectrometry. For example, the temperature is increased from room temperature at 5°C/min to measure the amount of the gases generated at 100°C to 300°C by mass spectrometry using TG-MAS. In order to keep down the amount of the gases generated, it is important that the adhesive does not contain a low-boiling-point compound as a component, does not have a site which is easily decomposed, and has a structure which less absorbs water and carbon dioxide gas. By using the heat-resistant adhesive generating a suppressed amount of gases, peeling of the metal layer due to the gases is eliminated to maintain high adhesion.

In addition, the heat-resistant adhesive is preferably as thin as possible to a degree causing no deterioration in adhesion. With an excessively thick adhesive, not only the properties of the heat-resistant resin film deteriorate, but also the inside of the adhesive layer deteriorates to adversely affect the heat resistance of the entire metal layer with resin. Therefore, the thickness of the adhesive is 0.01 µm to 10 µm, preferably 0.01 µm to 5 µm, and more preferably 0.01 µm to 3 µm. With a thickness of less than 0.01 µm, adhesion undesirably deteriorates.

Examples of aromatic tetracarboxylic acid used for a polyimide resin for obtaining the heat-resistant adhesive having the above-described properties include 3,3',4,4'-benzophenone tetracarboxylic dianhydride, 2,2',3,3'-benzophenone tetracarboxylic dianhydride, 2,2',3,3'-biphenyl tetracarboxylic dianhydride, pyromellitic dianhydride, 3,3',4,4'-biphenyl tetracarboxylic dianhydride, 2,2',3,3'-biphenyl tetracarboxylic dianhydride, 2,2-bis(3,4-dicarboxyphenyl)propane dianhydride, 2,2-bis(2,3-dicarboxyphenol)propane dianhydride, bis(3,4-dicarboxyphenyl) ether dianhydride, bis(3,4-dicarboxyphenyl)sulfone dianhydride, 1,1-bis(2,3-dicarboxyphenyl)ethane dianhydride, bis(2,3-dicarboxyphenyl)methane dianhydride, 2,3,6,7-naphthalenetetracarboxylic dianhydride, 1,4,5,8-naphthalenetetracarboxylic dianhydride, 1,2,5,6-naphthalenetetracarboxylic dianhydride, 1,2,3,4-benzenetetracarboxylic dianhydride, 3,4,9,10-perylenetetracarboxylic dianhydride, 2,3,6,7-anthracenetetracarboxylic dianhydride, 1,2,7,8-phenanthrenetetracarboxylic dianhydride, and the like. These carboxylic acids are used individually or in a mixture of at least two compounds,

A diamine used for a polyimide resin for obtaining the heat-resistant adhesive having the above properties is preferably at least 30 mol% or more of, more preferably 40 mol% or more of, siloxane-type diamine. The siloxane-type diamine used in the present invention is represented by the following formula [1]: 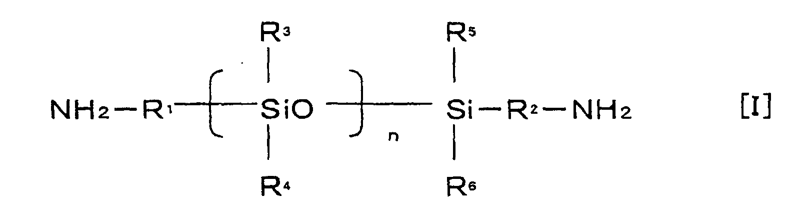 (wherein n represents an integer of 1 or more, R1 and R2 may be the same or different and each represent a lower alkylene group or a phenylene group, and R3, R4, R5 and R6 may be the same or different and each represent a lower alkyl group, a phenylene group, or a phenoxy group.)

Examples of siloxane-type diamines represented by formula [1] include 1,1,3,3-tetramethyl-1,3-bis(4-aminophenyl) disiloxane, 1,1,3,3-tetraphenoxy-1,3-bis(4-aminoethyl) disiloxane, 1,1,3,3,5,5-hexamethyl-1,5-bis(4-aminophenyl) trisiloxane, 1,1,3,3-tetraphenyl-1,3-(2-aminoethyl) disiloxane, 1,1,3,3-tetraphenyl-1,3-bis(3-aminopropyl) disiloxane, 1,1,5,5-tetraphenyl-3,3-dimethyl-1,5-bis(3-aminopropyl) trisiloxane, 1,1,5,5-tetraphenyl-3,3-dimethoxy-1,5-bis(4-aminobutyl) trisiloxane, 1,1,5,5-tetraphenyl-3,3-dimethoxy-1,5-bis(5-aminophentyl) trisiloxane, 1,1,3,3-tetramethyl-1,3-bis(2-aminoethyl) disiloxane, 1,1,3,3-tetramethyl-1,3-bis(3-aminopropyl) disiloxane, 1,1,3,3-tetramethyl-1,3-bis(4-aminobutyl) disiloxane, 1,3-dimethyl-1,3-dimethoxy-1,3-bis(4-aminobutyl) disiloxane, 1,1,5,5-tetramethyl-3,3-dimethoxy-1,5-bis(2-aminoethyl) trisiloxane, 1,1,5,5-tetramethyl-3,3-dimethoxy-1,5-bis(4-aminobutyl) trisiloxane, 1,1,5,5-tetramethyl-3,3-dimethoxy-1,5-bis(5-aminopentyl) trisiloxane, 1,1,3,3,5,5-hexamethyl-1,5-bis(3-aminopropyl) trisiloxane, 1,1,3,3,5,5-hexapropyl-1,5-bis(3-aminopropyl) trisiloxane, and the like. These siloxane-type diamines are used individually or in a mixture of at least two compounds.

As a diamine component other than the siloxane-type diamine, 4,4'-diaminodiphenyl ether, 4,4'-diaminodiphenyl methane, 4,4'-diaminodiphenyl sulfone, paraphenylenediamine, or the like can be used.

The method of obtaining polyamic acid as a polyimide precursor by reaction of an aromatic tetracarboxylic acid and diamine can be performed according to a conventional known method. For example, substantially stoichiometric amounts of acid component and diamine component may be reacted at a temperature of 0 to 80°C in an organic solvent such as N,N-dimethylformamide, N,N-dimethylacetamide, N-methyl-2-pyrrolidone, or the like. These solvents are used individually or in a mixture of at least two solvents, and benzene, toluene, hexane, cyclohexane, tetrahydrofuran, methyl ethyl ketone, or the like may be added to the solvent to an extent causing no precipitation of polyamic acid. The concentration of polyamic acid varnish is not limited, but the concentration is preferably 5 to 60% by weight, and more preferably 10 to 40% by weight. The resultant polyamic acid varnish is coated on the heat-resistant resin film, dried, and then imidized to form the heat-resistant adhesive comprising the polyimide resin on the heat-resistant resin film.

In the present invention, the metal layer is formed on the heat-resistant adhesive. As the method of forming the metal layer, a sputtering method, a vacuum evaporation method, a plating method, or a combination thereof may be used. Unlike in a method of bonding a copper foil, the method of forming the metal layer by sputtering, vacuum evaporation or plating forms a mixed layer containing the heat-resistant adhesive and the metal layer at the interface therebetween, thereby significantly improving adhesion between both layers. Once the mixed layer is formed, adhesive strength is maintained after the metal layer is patterned to form a wiring pattern, and thus the mixed layer is advantageous in forming fine wiring. Although copper, nickel, chromium, tin, zinc, lead, gold, rhodium, palladium, or the like can be used as a metal for forming the metal layer, the metal is not limited to these metals. These metals may be used individually or in a combination of at least two metals.

When the metal layer is formed by sputtering or vacuum evaporation, the metal is deposited to a proper thickness on the heat-resistant adhesive by sputtering or vacuum evaporation. As the sputtering or vacuum evaporation method, a known method may be used.

When the metal layer is formed by plating, plating is not performed directly on the adhesive, but plating is generally performed after a metal thin film serving as a nucleus is formed on the surface of the heat-resistant adhesive. The method of forming the metal thin film as the nucleus is divided into a wet process and a dry process. The wet process is further divided into a case in which the heat-resistant adhesive contains a catalytic nucleus, and a case in which the heat-resistant adhesive does not contain a catalytic nucleus. When the adhesive does not contain the catalytic nucleus, palladium, tin, nickel, or chromium is first applied as a catalyst to the surface of the heat-resistant adhesive, and if required, the applied catalyst is activated. When the adhesive contains the catalytic nucleus, if required, the catalyst on the surface of the heat-resistant adhesive is activated. In the dry process, chromium, nickel, tin, copper, palladium, gold, aluminum, or the like is deposited on the surface of the heat-resistant adhesive by sputtering or vacuum evaporation. However, a metal such as copper may be singly deposited by sputtering or vacuum evaporation, or a combination of chromium-copper, nickel-copper, or chromium-nickel may be deposited by sputtering or vacuum evaporation. Although the thickness of the metal thin film serving as the catalytic nucleus is not limited, the thickness is preferably 1 nm to 1000 nm, and more preferably 2 nm to 400 nm. With a thickness of over 1000 nm, much time is required for forming the metal thin film, while with a thickness of less than 1 nm, a defect occurs to damage plating, which will be described below.

Then, the metal layer is formed on the metal thin film by plating. The metal layer may be formed only by electroless plating, by a combination of electroless plating and electroplating, or only by electroplating. The electroless plating and electroplating can be performed by known methods. For example, in the case of electroless plating of copper, a combination of copper sulfate and formaldehyde is used. In the case of electroplating of copper, a copper sulfate plating solution, a copper cyanide plating solution, or a copper pyrophosphate plating solution may be used.

The thickness of the metal layer depends upon the way of processing the heat-resistant resin film with the metal layer. Namely, when a wiring board is formed by an additive process (semi-additive or full-additive process) using the heat-resistant resin film with the metal layer, a metal is further laminated on the metal layer by plating. Therefore, the thickness of the heat-resistant resin film with the metal layer is preferably in the range of 0.1 µm to 18 µm, and more preferably 0.1 µm to 10 µm. The thickness of less than 0.1 µm is undesirable because a defect easily occurs. The thickness of over 18 µm is also undesirable because much time is required for removing an excessive portion of the metal layer after the wiring board is formed by the additive process, and the shape of the formed wiring impaired. Conversely, when the wiring board is formed by a subtractive process using the heat-resistant resin film with the metal layer, a metal foil is used as wiring. Therefore, the thickness of the heat-resistant resin film with the metal layer is preferably in the range of 1 µm to 40 µm, and more preferably 3 µm to 18 µm. The thickness of less than 1 µm is undesirable because wiring is easily disconnected during formation. The thickness of over 40 µm is also undesirable because much time is required for forming wiring, and the shape of the formed wiring is impaired.

The method of forming the heat-resistant resin film with the metal layer comprises a series of steps, for example, according to the following procedure. First, a polyimide film as the heat-resistant resin film is treated with low-temperature plasma. Next, the polyamic acid varnish obtained as the polyimide resin heat-resistant adhesive from the siloxane-type diamine is coated on the polyimide film treated with low-temperature plasma. As the coating method, a roll coater, a knife coater, a seal coater, a comma coater, a doctor blade float coater, or the like can be used. After coating, the coating is generally dried at a temperature of 60°C to 200°C for 1 minute, and then imidized at a temperature of 200°C to 350°C. The drying time is 1 minute to 60 minutes, and the imidizing time is 5 minutes to 30 minutes, but these times are not limited. Then, a nickel-chromium alloy (nickel 90%-chromium 10% alloy) is deposited on the heat-resistant adhesive by sputtering, and then copper is deposited by sputtering. Finally, electroplating copper is performed by using the sputtered copper layer as an electrode to form the heat-resistant resin film with the metal layer.

In the present invention, the heat-resistant adhesive comprising the polyimide resin is formed on the heat-resistant resin film, and then at least one metal layer is formed on the adhesive by sputtering or vacuum evaporation. By forming the heat-resistant adhesive comprising the polyimide resin, strong adhesion can be obtained, as compared with a case in which the metal layer is formed directly on the heat-resistant resin film. Particularly, when the metal layer is etched in a predetermined wiring pattern, good adhesion can be obtained, causing an advantage in forming fine wiring.

In the present invention, the adhesion is represented by a value obtained by peeling a metal wiring pattern of 3 mm wide at a rate of 50 mm/min in the direction of 180 degrees according to JIS C5016 Section 7.1. The value is preferably 5 N/cm or more, and more preferably 10 N/cm or more. With the heat-resistant resin film with the metal layer of the present invention, a value of 10 N/cm or more can easily be obtained. Also, the heat-resistant adhesive is every thin, and thus the adhesive has the advantage that the properties basically possessed by the heat-resistant resin film are not deteriorated.

The heat-resistant resin film with the metal layer of the present invention is used for forming a wiring board by the additive process or subtractive process. The subtractive process comprises forming a resist layer on the metal layer, patterning the resist layer into a shape corresponding to a wiring pattern by exposure and development, etching the metal layer through the patterned resist layer used as a mask to form the wiring pattern, and then removing the resist layer to obtain a wiring board. The semi-additive process comprises forming a resist layer on the metal layer, removing the resist layer, by exposure and development, from a portion where a wiring pattern is formed, forming the wiring pattern in the portion without the resist layer by plating, removing the resist layer, and then removing the metal layer from a portion other than the wiring pattern to obtain a wiring board. Each of the thus-obtained wiring boards comprises the heat-resistant resin film and the metal wiring, which are strongly bonded together with the heat-resistant adhesive provided therebetween, and exhibits excellent heat resistance.

The heat-resistant resin film with the metal layer of the present invention has the metal layer provided on both or one of the sides of the heat-resistant resin film, and thus wiring is formed on the heat-resistant resin film by the additive or subtractive process to obtain a single-sided or double-sided wiring board. Therefore, the heat-resistant resin film can be preferably used for flexible wiring boards.

### Examples

Although the present invention will be described with reference to examples, the present invention is not limited to these examples. In a description below, in Examples 1 to 15 and Comparative Examples 1 to 3, adhesion was evaluated and measured by the following methods.
1. Adhesion: Adhesive strength was measured according to JIS C6481 (180° peel).
2. Heat resistance: A wiring pattern of 2 mm wide was formed by the additive or subtractive process, maintained in a hot-air oven of 150°C for 240 hours, taken out of the oven, and then evaluated with respect to adhesion.
3. Tin plating: A wiring pattern of 2 mm wide was formed by the additive or subtractive process, tinned by electroless plating, washed with water, dried, and then evaluated with respect to adhesion. The tinning conditions were as follows:
   Electroless tinning solution: TINPOSIT LT-34 (produced by Shipley Far East, Ltd.)
   Water-washing time: 2 minutes at 25°C
   Plating time: 5 minutes at 70°C
   Drying: 30 minutes at 50°C

### Example 1

112.5 g of N,N-dimethylacetamide was placed in a 300-ml four-neck flask with a thermometer, a stirrer, a reflux condenser, and a dry nitrogen gas inlet port, and 16.2 g (99 mol%) of 1,1,3,3-tetramethyl-1,3-bis(3-aminopropyl) disiloxane and 0.07 g (1 mol%) of p-phenylenediamine were dissolved under a nitrogen flow. Then, 21.22 g (100 mol%) of 3,3',4,4'-benzophenonetetracarboxylic dianhydride was added to the resultant solution, and then stirred at 10°C for 1 hour. Then, the mixture was reacted by further stirring at 50°C for 3 hours to obtain polyamic acid varnish.

The thus-obtained varnish was coated on one side of a polyimide film ("Kapton" 100EN produced by Du Pont-Toray Co., Ltd.), which was a heat-resistant resin film of 25 µm treated with low-temperature plasma in an argon atmosphere, by a bar coater so that the thickness after drying was 3 µm. Then, heat treatment was performed at 130°C for 3 minutes, 150°C for 3 minutes, and further 270°C for 3 minutes to dry and imidize the coated film. As a result, a heat-resistant adhesive comprising the polyimide resin was formed on one side of the heat-resistant resin film. The glass transition temperature (Tg) of the heat-resistant adhesive was 92°C, the elastic modulus at 200°C was 0.4 GPa, and the amount of the gases generated at 100 to 300°C was 90 ppm.

Then, chromium was deposited to a thickness of 4 nm on the heat-resistant adhesive by sputtering, and copper was deposited to a thickness of 200 nm by sputtering. After sputtering, electrolytic copper plating was performed to a thickness of 8 µm by using a copper sulfate bath with a current density of 2 A/dm² to obtain the heat-resistant resin film with a metal layer.

### Example 2

The varnish obtained in Example 1 was coated on one side of a polyimide film of 25 µm thick ("Upilex" 25S produced by Ube Industries, Ltd.) treated with plasma by the same method as Example 1 so that the thickness after drying was 0.5 µm, dried and then imidized by the same method as Example 1 to form a heat-resistant adhesive comprising the polyimide resin on the heat-resistant resin film. The glass transition temperature (Tg) of the heat-resistant adhesive was 92°C, the elastic modulus at 200°C was 0.4 GPa, and the amount of the gases generated at 100 to 300°C was 90 ppm.

Then, nickel was deposited to a thickness of 10 nm on the heat-resistant adhesive by sputtering, and copper was deposited to a thickness of 100 nm by sputtering. After sputtering, copper plating was performed to a thickness of 2 µm by the same method as Example 1 to obtain the heat-resistant resin film with a metal layer.

### Example 3

The varnish obtained in Example 1 was coated on one side of a liquid crystal polymer film of 25 µm thick ("Biac" produced by Japan Gore-Tex Inc.) treated with plasma by the same method as Example 1 so that the thickness after drying was 9 µm, dried and then imidized by the same method as Example 1 to form a heat-resistant adhesive comprising the polyimide resin on the heat-resistant resin film. The glass transition temperature (Tg) of the heat-resistant adhesive was 92°C, the elastic modulus at 200°C was 0.4 GPa, and the amount of the gases generated at 100 to 300°C was 90 ppm.

Then, a nickel-chromium alloy (nickel 95%-chromium 5%) was deposited to a thickness of 6 nm on the heat-resistant adhesive by sputtering, and copper was deposited to a thickness of 350 nm by sputtering. After sputtering, copper plating was performed to a thickness of 15 µm by the same method as Example 1 to obtain the heat-resistant resin film with a metal layer.

### Example 4

112.5 g of N,N-dimethylacetamide was placed in a 300-ml four-neck flask with a thermometer, a stirrer, a reflux condenser, and a dry nitrogen gas inlet port, and 6.94 g (40 mol%) of 1,1,3,3-tetramethyl-1,3-bis(3-aminopropyl) disiloxane and 11.79 g (60 mol%) of diaminodiphenyl ether were dissolved under a nitrogen flow. Then, 21.32 g (100 mol%) of 3,3',4,4'-benzophenonetetracarboxylic dianhydride was added to the resultant solution, and then stirred at 10°C for 1 hour. Then, the mixture was reacted by further stirring at 50°C for 3 hours to obtain polyamic acid varnish.

The thus-obtained varnish was coated on one side of a polyimide film ("Kapton" 100EN produced by Du Pont-Toray Co., Ltd.), which was a heat-resistant resin film of 25 µm treated with low-temperature plasma in an argon atmosphere, by a bar coater so that the thickness after drying was 3 µm. Then, heat treatment was performed at 130°C for 3 minutes, 150°C for 3 minutes, and further 270°C for 3 minutes to dry and imidize the coated film. As a result, a heat-resistant adhesive was formed on one side of the heat-resistant resin film. The glass transition temperature (Tg) of the heat-resistant adhesive was 175°C, the elastic modulus at 200°C was 1.3 GPa, and the amount of the gases generated at 100 to 300°C was 60 ppm.

Then, chromium was deposited to a thickness of 4 nm on the heat-resistant adhesive by sputtering, and copper was deposited to a thickness of 200 nm by sputtering. After sputtering, electrolytic copper plating was performed to a thickness of 8 µm by using a copper sulfate bath with a current density of 2 A/dm² to obtain the heat-resistant resin film with a metal layer.

### Example 5

The varnish obtained in Example 4 was coated on one side of a polyimide film of 25 µm thick ("Upilex" 25S produced by Ube Industries, Ltd.) treated with plasma by the same method as Example 4 so that the thickness after drying was 0.5 µm, dried and then imidized by the same method as Example 4 to form a heat-resistant adhesive on the heat-resistant resin film. The glass transition temperature (Tg) of the heat-resistant adhesive was 175°C, the elastic modulus at 200°C was 1.3 GPa, and the amount of the gases generated at 100 to 300°C was 60 ppm.

Then, nickel was deposited to a thickness of 10 nm on the heat-resistant adhesive by sputtering, and copper was deposited to a thickness of 100 nm by sputtering. After sputtering, copper plating was performed to a thickness of 2 µm by the same method as Example 4 to obtain the heat-resistant resin film with a metal layer.

### Example 6

The varnish obtained in Example 4 was coated on one side of a liquid crystal polymer film of 25 µm thick ("Biac" produced by Japan Gore-Tex Inc.) treated with plasma by the same method as Example 4 so that the thickness after drying was 9 µm, dried and then imidized by the same method as Example 4 to form a heat-resistant adhesive on the heat-resistant resin film. The glass transition temperature (Tg) of the heat-resistant adhesive was 175°C, the elastic modulus at 200°C was 1.3 GPa, and the amount of the gases generated at 100 to 300°C was 60 ppm.

Then, a nickel-chromium alloy (nickel 95%-chromium 5%) was deposited to a thickness of 6 nm on the heat-resistant adhesive by sputtering, and copper was deposited to a thickness of 350 nm by sputtering. After sputtering, copper plating was performed to a thickness of 15 µm by the same method as Example 4 to obtain the heat-resistant resin film with a metal layer.

### Example 7

140 g of N,N-dimethylacetamide was placed in a 300-ml four-neck flask with a thermometer, a stirrer, a reflux condenser, and a dry nitrogen gas inlet port, and 10.2 g (65 mol%) of 1,1,3,3-tetramethyl-1,3-bis(3-aminopropyl) disiloxane and 4.42 g (35 mol%) of diaminodiphenyl ether were dissolved under a nitrogen flow. Then, 20.36 g (100 mol%) of 3,3',4,4'-benzophenonetetracarboxylic dianhydride was added to the resultant solution, and then stirred at 10°C for 1 hour. Then, the mixture was reacted by further stirring at 50°C for 3 hours to obtain polyamic acid varnish.

The thus-obtained varnish was coated on one side of a polyimide film ("Kapton" 100EN produced by Du Pont-Toray Co., Ltd.), which was a heat-resistant resin film of 25 µm treated with low-temperature plasma in an argon atmosphere, by a bar coater so that the thickness after drying was 3 µm. Then, heat treatment was performed at 130°C for 3 minutes, 150°C for 3 minutes, and further 270°C for 3 minutes to dry and imidize the coated film. As a result, a heat-resistant adhesive was formed on one side of the heat-resistant resin film. The glass transition temperature (Tg) of the heat-resistant adhesive was 160°C, the elastic modulus at 200°C was 0.9 GPa, and the amount of the gases generated at 100 to 300°C was 70 ppm.

Then, chromium was deposited to a thickness of 4 nm on the heat-resistant adhesive by sputtering, and copper was deposited to a thickness of 200 nm by sputtering. After sputtering, electrolytic copper plating was performed to a thickness of 8 µm by using a copper sulfate bath with a current density of 2 A/dm² to obtain the heat-resistant resin film with a metal layer.

### Example 8

The varnish obtained in Example 7 was coated on one side of a polyimide film of 25 µm thick ("Upilex" 25S produced by Ube Industries, Ltd.) treated with plasma by the same method as Example 7 so that the thickness after drying was 0.5 µm, dried and then imidized by the same method as Example 7 to form a heat-resistant adhesive on the heat-resistant resin film. The glass transition temperature (Tg) of the heat-resistant adhesive was 160°C, the elastic modulus at 200°C was 0.9 GPa, and the amount of the gases generated at 100 to 300°C was 70 ppm.

Then, nickel was deposited to a thickness of 10 nm on the heat-resistant adhesive by sputtering, and copper was deposited to a thickness of 100 nm by sputtering. After sputtering, copper plating was performed to a thickness of 2 µm by the same method as Example 7 to obtain the heat-resistant resin film with a metal layer.

### Example 9

The varnish obtained in Example 7 was coated on one side of a liquid crystal polymer film of 25 µm thick ("BIAC" produced by Japan Gore-Tex Inc.) treated with plasma by the same method as Example 7 so that the thickness after drying was 9 µm, dried and then imidized by the same method as Example 7 to form a heat-resistant adhesive on the heat-resistant resin film. The glass transition temperature (Tg) of the heat-resistant adhesive was 160°C, the elastic modulus at 200°C was 0.9 GPa, and the amount of the gases generated at 100 to 300°C was 70 ppm.

Then, a nickel-chromium alloy (nickel 95%-chromium 5%) was deposited to a thickness of 6 nm on the heat-resistant adhesive by sputtering, and copper was deposited to a thickness of 350 nm by sputtering. After sputtering, copper plating was performed to a thickness of 15 µm by the same method as Example 7 to obtain the heat-resistant resin film with a metal layer.

### Example 10

140 g of N,N-dimethylacetamide was placed in a 300-ml four-neck flask with a thermometer, a stirrer, a reflux condenser, and a dry nitrogen gas inlet port, and 13.1 g (95 mol%) of 1,1,3,3-tetramethyl-1,3-bis(3-aminopropyl) disiloxane and 1.86 g (15 mol%) of diaminodiphenyl ether were dissolved under a nitrogen flow. Then, 20.01 g (100 mol%) of 3,3',4,4'-benzophenonetetracarboxylic dianhydride was added to the resultant solution, and then stirred at 10°C for 1 hour. Then, the mixture was reacted by further stirring at 50°C for 3 hours to obtain polyamic acid varnish.

The thus-obtained varnish was coated on one side of a polyimide film ("Kapton" 100EN produced by Du Pont-Toray Co., Ltd.), which was a heat-resistant resin film of 25 µm treated with low-temperature plasma in an argon atmosphere, by a bar coater so that the thickness after drying was 3 µm. Then, heat treatment was performed at 130°C for 3 minutes, 150°C for 3 minutes, and further 270°C for 3 minutes to dry and imidize the coated film. As a result, a heat-resistant adhesive was formed on one side of the heat-resistant resin film. The glass transition temperature (Tg) of the heat-resistant adhesive was 130°C, the elastic modulus at 200°C was 0.62 GPa, and the amount of the gases generated at 100 to 300°C was 50 ppm.

Then, chromium was deposited to a thickness of 4 nm on the heat-resistant adhesive by sputtering, and copper was deposited to a thickness of 200 nm by sputtering. After sputtering, electrolytic copper plating was performed to a thickness of 8 µm by using a copper sulfate bath with a current density of 2 A/dm² to obtain the heat-resistant resin film with a metal layer.

### Example 11

The varnish obtained in Example 10 was coated on one side of a polyimide film of 25 µm thick ("Upilex" 25S produced by Ube Industries, Ltd.) treated with plasma by the same method as Example 10 so that the thickness after drying was 0.5 µm, dried and then imidized by the same method as Example 10 to form a heat-resistant adhesive on the heat-resistant resin film. The glass transition temperature (Tg) of the heat-resistant adhesive was 130°C, the elastic modulus at 200°C was 0.62 GPa, and the amount of the gases generated at 100 to 300°C was 50 ppm.

Then, nickel was deposited to a thickness of 10 nm on the heat-resistant adhesive by sputtering, and copper was deposited to a thickness of 100 nm by sputtering. After sputtering, copper plating was performed to a thickness of 2 µm by the same method as Example 10 to obtain the heat-resistant resin film with a metal layer.

### Example 12

The varnish obtained in Example 10 was coated on one side of a liquid crystal polymer film of 25 µm thick ("Biac" produced by Japan Gore-Tex Inc..) treated with plasma by the same method as Example 10 so that the thickness after drying was 9 µm, dried and then imidized by the same method as Example 10 to form a heat-resistant adhesive on the heat-resistant resin film. The glass transition temperature (Tg) of the heat-resistant adhesive was 130°C, the elastic modulus at 200°C was 0.62 GPa, and the amount of the gases generated at 100 to 300°C was 50 ppm.

Then, a nickel-chromium alloy (nickel 95%-chromium 5%) was deposited to a thickness of 6 nm on the heat-resistant adhesive by sputtering, and copper was deposited to a thickness of 350 nm by sputtering. After sputtering, copper plating was performed to a thickness of 15 µm by the same method as Example 10 to obtain the heat-resistant resin film with a metal layer.

### Example 13

The same procedure as Example 1 was repeated except that chromium was deposited to a thickness of 4 nm by vacuum evaporation instead of being deposited to a thickness of 4 nm by sputtering, to obtain a heat-resistant resin film with a metal layer.

### Example 14

The same procedure as Example 2 was repeated except that nickel was deposited to a thickness of 10 nm by vacuum evaporation instead of being deposited to a thickness of 10 nm by sputtering, to obtain a heat-resistant resin film with a metal layer.

### Example 15

The same procedure as Example 3 was repeated except that a nickel-chromium alloy (nickel 95%-chromium 5%) was deposited to a thickness of 6 nm by vacuum evaporation instead of being deposited to a thickness of 6 nm by sputtering, to obtain a heat-resistant resin film with a metal layer.

### Comparative Example 1

Chromium was deposited to a thickness of 4 nm on one side of a polyimide film ("Kapton" 100EN produced by Du Pont-Toray Co., Ltd.), which was a heat-resistant resin film of 25 µm treated with low-temperature plasma in an argon atmosphere, by sputtering in the same manner as Example 1, and then copper was deposited to a thickness of 200 nm by sputtering. After sputtering, electrolytic copper plating was performed to a thickness of 8 µm by using a copper sulfate bath with a current density of 2 A/dm² to obtain the heat-resistant resin film with a metal layer.

### Comparative Example 2

Nickel was deposited to a thickness of 10 nm on one side of a polyimide film of 25 µm thick ("Upilex" 25S produced by Ube Industries, Ltd.) treated with low-temperature plasma in an argon atmosphere, by sputtering in the same manner as Example 2, and then copper was deposited to a thickness of 100 nm by sputtering. After sputtering, copper plating was performed to a thickness of 2 µm by the same method as Example 2 to obtain a heat-resistant resin film with a metal layer.

### Comparative Example 3

A nickel-chromium alloy (nickel 95%-chromium 5%) was deposited to a thickness of 6 nm on one side of a liquid crystal polymer film of 25 µm thick ("BIAC" produced by Japan Gore-Tex Inc..) treated with low-temperature plasma in an argon atmosphere by sputtering in the same manner as Example 3, and then copper was deposited to a thickness of 350 nm by sputtering. After sputtering, copper plating was performed to a thickness of 15 µm by the same method as Example 3 to obtain a heat-resistant resin film with a metal layer.

### Example 16

Photoresist was coated on the metal layer of the heat-resistant resin film with the metal layer obtained in Example 1 so that the dry film thickness was 5 µm, dried, and then patterned by exposure and development through a mask corresponding to a wiring pattern having a line width of 5 to 100 µm, to obtain a resist pattern having the remaining wiring layer pattern. Then, the metal layer in the portion in which the resist was removed was etched with a 10% iron chloride aqueous solution, and further etched with a 20% potassium ferricyanide aqueous solution containing 5% of sodium hydroxide. Then, the photoresist was removed to obtain a single-sided wiring board. In the thus-obtained wiring board, thin wiring of 5 µm in thickness, and relatively thick wiring of 100 µm in thickness were strongly bonded without a defect in the wiring pattern.

### Example 17

Photoresist was coated on the metal layer of the heat-resistant resin film with the metal layer obtained in Example 2 so that the dry film thickness was 5 µm, dried, and then patterned by exposure and development through a mask corresponding to a wiring pattern having a line width of 5 to 100 µm, to obtain a resist pattern in which the wiring layer pattern was removed. Then, in the portion in which the resist was removed, electroless copper plating was performed to a thickness of 0.5 µm on the metal layer, and electrolytic copper plating was performed to a thickness of 3.5 µm. Then, electrolytic nickel plating was performed to a thickness of 0.5 µm, and then electrolytic gold plating was performed to a thickness of 3.5 µm so that the final thickness was 5 µm the same as the resist layer. After plating, the resist was removed, and the metal layer was removed from the portion other than the wiring pattern by soft etching with a 5% iron chloride aqueous solution to obtain a single-sided wiring board. In the thus obtained wiring board, thin wiring of 5 µm in thickness, and relatively thick wiring of 100 µm in thickness were strongly bonded without a defect in the wiring pattern.

The results of Examples 1 to 15 and Comparative Examples 1 to 3 are summarized in Table 1.

| | Adhesive Strength^{*1} (N/cm) | | |
|---|---|---|---|
| | Initial | After heat load | After tinning |
| Example 1 | 10 | 9 | 9 |
| Example 2 | 10 | 9 | 9 |
| Example 3 | 10 | 9 | 9 |
| Example 4 | 10 | 9 | 9 |
| Example 5 | 10 | 9 | 9 |
| Example 6 | 10 | 9 | 9 |
| Example 7 | 8 | 7 | 7 |
| Example 8 | 8 | 8 | 8 |
| Example 9 | 8 | 8 | 8 |
| Example 10 | 9 | 8 | 9 |
| Example 11 | 9 | 9 | 9 |
| Example 12 | 9 | 8 | 9 |
| Example 13 | 8 | 7 | 7 |
| Example 14 | 8 | 7 | 7 |
| Example 15 | 8 | 7 | 7 |
| Comp. Example 1 | 4 | 1 | 2 |
| Comp. Example 2 | 2 | 1 | 1 |
| Comp. Example 3 | 2 | 1 | 1 |

| | | | |
|---|---|---|---|
| *1 The practical level of adhesive strength is 5 N/cm or more. | | | |

### Industrial Applicability

In the present invention, a heat-resistant resin film with a metal layer comprises a metal layer formed on the heat-resistant resin film by sputtering, vacuum evaporation or plating using a heat-resistant adhesive comprising a polyimide resin. Therefore, the physical properties possessed by the heat-resistant resin film can be sufficiently utilized, and the metal layer is strongly bonded to the heat-resistant resin film. A wiring board obtained by using the heat-resistant resin film with the metal layer has less defect in a wiring pattern, and the like, and thus has excellent properties.

## Claims

1. A heat-resistant resin film with a metal layer comprising a heat-resistant adhesive coated on at least one side of the heat-resistant resin film, the metal layer being provided on the heat-resistant adhesive, wherein the heat-resistant adhesive comprises a polyimide resin, and is provided by at least one of sputtering, vacuum evaporation, and plating.

2. A method of forming a heat-resistant resin film with a metal layer according to Claim 1, the method comprising coating a heat-resistant adhesive on at least one side of the heat-resistant resin film, and then providing the metal layer by at least one of sputtering, vacuum evaporation, and plating.

3. A heat-resistant resin film with a metal layer according to Claim 1, wherein the metal layer formed by at least sputtering or vacuum evaporation has a thickness of 2 nm to 400 nm, and the metal layer formed by plating has a thickness of 0.1 µm to 18 µm.

4. A heat-resistant resin film with a metal layer according to Claim 1, wherein the heat-resistant adhesive has a glass transition temperature (Tg) of 60°C to 250°C.

5. A heat-resistant resin film with a metal layer according to Claim 1, wherein the heat-resistant adhesive has a glass transition temperature (Tg) of 60°C to 230°C.

6. A heat-resistant resin film with a metal layer according to Claim 1, wherein the amount of the gases generated from the heat-resistant adhesive at 100°C to 300°C is 250 ppm or less.

7. A heat-resistant resin film with a metal layer according to Claim 1, wherein the heat-resistant adhesive has an elastic modulus of 0.1 GPa to 3 GPa at 200°C.

8. A heat-resistant resin film with a metal layer according to Claim 1, wherein the heat-resistant adhesive has a thickness of 0.01 µm to 10 µm.

9. A heat-resistant resin film with a metal layer according to Claim 1, wherein the polyimide resin comprises an aromatic tetracarboxylic dianhydride and a diamine, and the diamine is a siloxane-type diamine.

10. A wiring board comprising a heat-resistant resin film with a metal layer according to Claim 1, wherein the metal layer is formed in a wiring pattern.

11. A method of producing a wiring board comprising patterning a metal layer of a heat-resistant resin film with a metal layer according to Claim 1 to form a wiring pattern.

12. A heat-resistant resin film with a metal layer according to Claim 1, wherein the metal layer comprises at lest one metal selected from the group consisting of chromium, nickel, lead, zinc, tin, gold, silver, palladium, and copper.

13. A wiring board comprising a heat-resistant resin film with a metal layer according to Claim 1, wherein the metal layer is formed in a wiring pattern by forming a resist layer on the metal layer, patterning the resist layer in a shape corresponding to the wiring pattern by exposure and development, etching the metal layer by using the patterned resist layer as an etching mask to form the wiring pattern, and then removing the resist layer.

14. A wiring board comprising a heat-resistant resin film with a metal layer according to Claim 1, wherein the metal layer is formed in a wiring pattern by forming a resist layer on the metal layer, removing, by exposure and development, the resist layer from a portion where the wiring pattern is formed, forming the wiring pattern by plating in the portion in which the resist layer is removed, and then removing the resist layer to remove the metal layer from a portion other than the wiring pattern.
